(19) **Europäisches Patentamt**
**European Patent Office**
**Office européen des brevets**

(11) **EP 3 495 833 A1**

(12) **EUROPEAN PATENT APPLICATION**

(43) Date of publication:
**12.06.2019 Bulletin 2019/24**

(51) Int Cl.:
**G01R 35/02** *(2006.01)*     *G01R 19/25* *(2006.01)*
**G01R 31/02** *(2006.01)*

(21) Application number: **17460073.4**

(22) Date of filing: **07.12.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **ABB Schweiz AG**
**5400 Baden (CH)**

(72) Inventors:
• **Smolana, Michal**
  **31-421 Krakow (PL)**
• **Dawidowski, Pawel**
  **30-707 Krakow (PL)**
• **Krakowski, Marcin**
  **04-282 Warszawa (PL)**

(74) Representative: **Chochorowska-Winiarska, Krystyna**
  **ABB Sp. z o. o.**
  **ul. Zeganska 1**
  **04-713 Warszawa (PL)**

(54) **A METHOD OF COMPENSATING CURRENT TRANSFORMER ERRORS**

(57) The subject of the invention is a method of compensating current transformer errors of numbers of current transformers (6) working in the system connected to the common node busbar (3) in electrical stations or substations (1). The method is characterized in that has a step of connecting a secondary winding of each transformer (6) with a protection electronic device (5) or with a central control unit (8), the step of measuring the current signals $\overline{I}_m$ of each of the m-current transformer (6) in a given by a user time intervals ($\Delta$t), the step of determination a matrix of an error ratio $\left( \overline{E}_1 \cdot \overline{E}_n^{-1} \right)$, where $\overline{E}_n$ is a complex error introduced by n current transformer and $\overline{E}_n^{-1}$ is an inversed complex error introduced by current transformer and a step of updated automatically the complex error $(\overline{E}_n)$ for each current transformer.

Fig. 4

**Description**

**FIELD OF INVENTION**

The subject of the invention is a method of compensating current transformer errors of numbers of current transformers working in the system connected to the common node busbar in electrical stations or substations.

**STATE OF THE ART**

The common method used to validate a current transformer measurements is to compare the secondary current of a standard current transformer with identically rated transformer ratio as the current transformer under test and with an accuracy better than 10 times compared to the secondary current of the current transformer.

The US2016209446 patent describes calculation of a ratio correction factor and a phase error of a current transformer comprises the steps of respectively receiving a ratio correction factor and a phase error for at least two different burden of a current transformer combine data. The correction factors are calculated by characterizing circuit connected to at least one current transformer and electrically coupled to communication interface. The drawback of this method is that the data for characterization circuit is collected only during test conditions not during normal operation of current transformer. Method mentioned in KR101431685 is based on calculation of current transformer equivalent circuit parameters based on two measurements with two different burden connected to the secondary circuit. The limitation of this method is that equivalent circuit must be calculated for each current transformer.

**SUMARY OF THE INVENTION**

A method of compensating current transformer errors according to the invention comprising the following steps:

- connecting a secondary winding of each transformer with a protection electronic device installed in the automation station or with a central control unit through electronic device and communication channel,
- measuring the current signals $\overline{I}_{mn}$ of each of the n-current transformer in a given by a user time intervals $\Delta t$ for preparing at least two sets of measured data, where each set comprises measured current signals $\overline{I}_{m\_n}$ ,
- determination a matrix of an error ratio $\overline{E}_1 \cdot \overline{E}_n^{-1}$ for all n$^{th}$ current transformer with the two sets of measured data according to the formula:

$$\begin{bmatrix} \overline{E}_1 \cdot \overline{E}_2^{-1} \\ \overline{E}_1 \cdot \overline{E}_3^{-1} \\ \vdots \\ \overline{E}_1 \cdot \overline{E}_n^{-1} \end{bmatrix} = \begin{bmatrix} -\overline{I}_{mA1} \\ -\overline{I}_{mB1} \end{bmatrix} \begin{bmatrix} \overline{I}_{mA2} & \overline{I}_{mA3} & \cdots & \overline{I}_{mAn} \\ \overline{I}_{mB2} & \overline{I}_{mB3} & \cdots & \overline{I}_{mBn} \end{bmatrix}^{-1}$$

where:

$\overline{I}_{mAn}$ - is a signal measured by n$^{th}$ current transformer for the first set A,

$\overline{I}_{mBn}$ - is a signal measured by n$^{th}$ current transformer for the second set B after time interval $\Delta t$,

$\overline{E}_n$- is a complex error introduced by n current transformer,

$\overline{E}_n^{-1}$ - is an inversed complex error introduced by current transformer,

- and updated automatically the complex error $\overline{E}_n$ for each current transformer using the matrix of an error ratio $\overline{E}_1 \cdot \overline{E}_n^{-1}$ detrmined in the previous steps.

Preferably the method is realized in the protection electronic device with using an analog to digital module for gathering measured signals $\overline{I}_{m\_n}$ for at least two current transformers and using and a communication module for communication with other protection electronic device through a communication channel.

Preferably the method is realized in the protection electronic device with using an analog to digital module for

gathering measured signals $\bar{I}_{m\_n}$ for at least two current transformers and using and a communication module for communication with a central control unit through a communication channel.

Preferably the protection electronic device is protection relay or a merging unit.

Preferably the central control unit is an industrial PC or a substation server.

The essence of a computer program product according to the invention is that during program run it executes the method according to any claims 1-5.

## ADVANTAGES OF THE INVENTION

System provides online solution for calculation of current transformers errors. The current transformers errors are calculated on bay or station level and then send back for update to bay units. The calculation can be made in settable time intervals in orden not to increase computational and communication burden. Utilizing of such solution provide improvement in measurements accuracy by analyzing the measured current connected to one electrical bus

## DETAILED DESCRIPTION

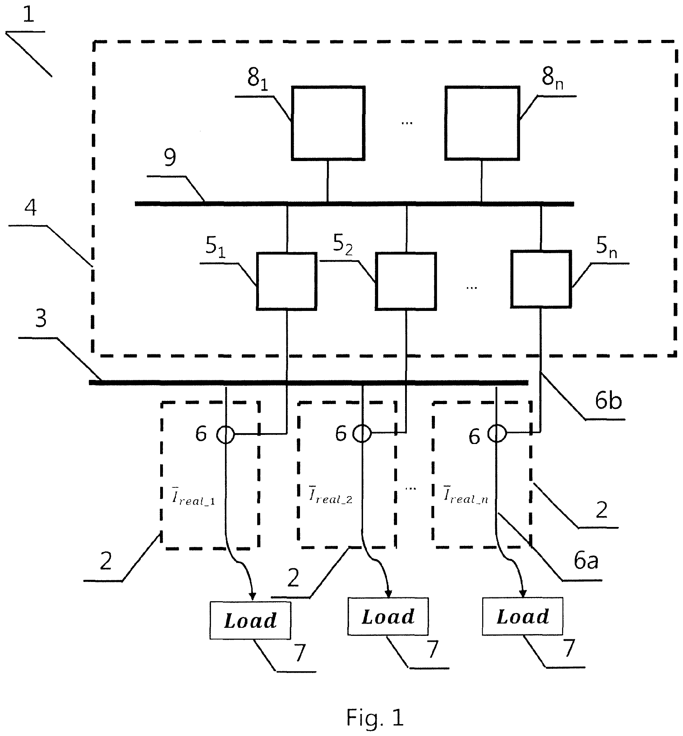

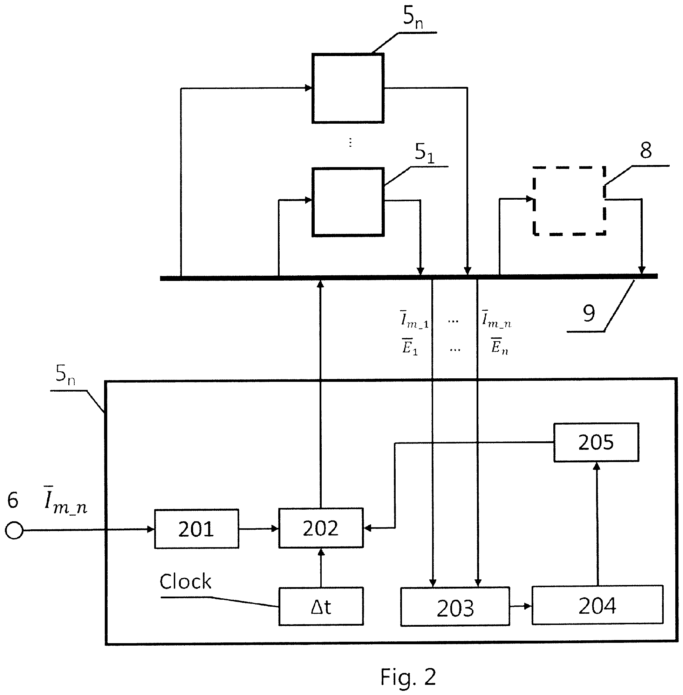

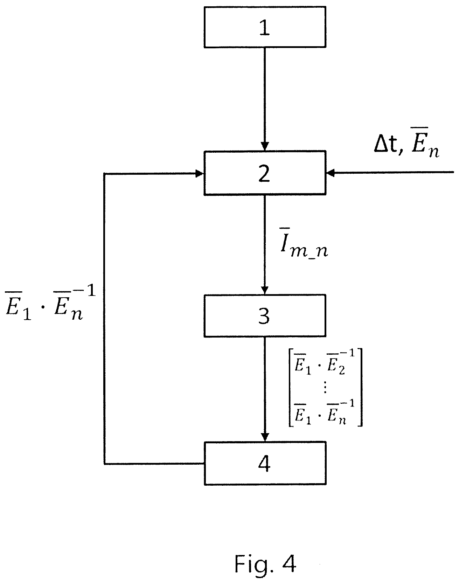

A method according to the invention is presented in the exemplary embodiment on the drawing where fig.1 presents a substation scheme in which the method is used, fig.2 presents an electronic protection device from fig.1 in details, fig.2 presents a central control unit from fig.1 in details, and fig.4 present a flowchart of the invented method.

The switching substation 1 is equipped with a plurality of n-switch bays 2 (n is a natural number) connected electrically through a common node busbar 3 with a substation automation station 4 having at least one protection electronic device 5. Each of the n-switch bay comprises a current transformer 6 to which a load 7 is connected through a conductor 6a. Each current transformer 6 is electrically connected through a secondary winding and a conductor 6b with the electronic device 5. The electronic device 5 is a computer device with a processor having a standard hardware. The electronic device 5 have been communicated with themselves aby a communication channel 9. To the communication channel a central control unit 8 is connected. Each of the electronic device 5, for example 5n is equipped with an analog to digital converter module 201 which is communicated with others measuring devices 51...5n-1 trough an communication module 202 transferring the measured signal, burden with a complex error characterising each current transformer, from each other measuring devices 51...5n-1 working in the same time as device 5n. The measured current signals $\bar{I}_{m\_n}$ from each other devices 51...5n-1 are gathered in a gathering module 203 of the electronic device 5n and next are processed in a calculation module 204 for calculation of error matrix. Calculated data are transferred to a buffer module 205 for gathering and registering processed data and next sent them back to the communication module 202 for updated the value of the current signals $\bar{I}_{m\_n}$ delivered to this module from the current transformer 6 being under investigation.

A method according to the invention is realized in the following steps:

## Step #1

In the step #1 a system or current transformers 6 of switch bays are built for measuring the current flowing through a conductor 6a, connected with the load 7 and a primary winding of the current transformer. A secondary winding of current transformer 6 is configured with a protection electronic device 5 installed in the automation station 4 or with a central control unit 8 through electronic device 5. Each of the protection electronic device 5 and central control unit 8 are communicated together through a communication channel 9.

## Step #2

In the step #2 a measuring the current signals $\bar{I}_{m\_n}$ of each of the current transformer 6 (n is natural number of transformers) in a given by a user time intervals, defined as $\Delta t$, is performed. Next the process of converting the analog measured signals into a digital values is performed in a module 201 of the protection electronic device device 5. The digital signals are preprocessed in a communication module 202 in which a complex error $\overline{E_n}$ is determined for each of the transformer 61 ...6n. If the current transformer is connected with the central unit 8 the measured signal is delivered to the communication module 202 directly from electronic device 5. The complex error $\overline{E_n}$ is determined from the following formula:

$$\bar{I}_{m\_n} = \bar{I}_{real\_n} \cdot Amp_n{}^{j\delta_n} = \bar{I}_{real\_n} \cdot \overline{E_n} \qquad (1.1),$$

where:

$\overline{I}_{m\_n}$ - signals measured by $n^{th}$ current transformers,

$\overline{I}_{real\_n}$ - current that flow in conductor connecting load and common node busbar,

$Amp_n$ - amplitude error introduced by n- current transformer,

$\delta_n$ -phase error introduced by $n^{th}$ current transformer.

**Step #3**

In the step #3 a calculating process is performed in order to receive an inversed complex error $\overline{E_n}^{-1}$ , introduced by $n^{th}$ transformer for each transformer in a calculation module 204 of the device 5 of the unit 8, according to the formula:

$$\overline{I}_{real\_n} = \overline{I}_{m\_n} \cdot \overline{E_n}^{-1} \qquad (1.2)$$

where:

$\overline{I}_{m\_n}$ - signal measured by $n^{th}$ - current transformer,

$\overline{I}_{real\_n}$ - current flowing in conductor connecting the load 7 and common node busbar 3,

and next using the Kirchoff's law a calculation a sum of the measured current signals $\overline{I}_{m\_n}$ of all current transformers is performed according to the formula:

$$\sum_{n=1}^{i} \overline{I}_{m\_n} = 0 \qquad (1.3).$$

Next the sum of the measured current signals $\overline{I}_{m\_n}$ is multiplied by the inverted complex errors $\overline{E_n}^{-1}$ for each current transformer according to the formula:

$$\sum_{n=1}^{i} \overline{I}_{mn} \cdot \overline{E_n}^{-1} = \overline{I}_{m1} \cdot \overline{E_1}^{-1} + \overline{I}_{m2} \cdot \overline{E_2}^{-1} + \cdots + \overline{I}_{mn} \cdot \overline{E_n}^{-1} = 0 \qquad (1.4)$$

where:

$\overline{I}_{m-n}$ - signal measured by $n^{th}$ current transformer,

$\overline{I}_{real\_n}$ - current flowing in conductor 6a connecting load 7 and common node busbar 3.

Next from the sum of the measured current signals $\overline{I}_{m\_n}$ multiplied by the inverted complex errors $\overline{E_n}^{-1}$ a new individual current signal $-\overline{I}_{m\_1}$ is calculated in a module 204 according to the formula:

$$-\overline{I}_{m\_1} = \overline{I}_{m\_2} \cdot \frac{\overline{E_1}}{\overline{E_2}} + \cdots + \overline{I}_{m\_n} \cdot \frac{\overline{E_1}}{\overline{E_n}} \qquad (1.5)$$

where:

$\overline{I}_{m\_n}$ - signal measured by $n^{th}$ current transformer,

$\overline{E}_n$-complex error introduced by $n^{th}$ current transformer.

Next all new individual current signals $\overline{I}_{m\_n}$ of nth current transformers for the measuring signals are gathered in a calculating module 204 as two data sets A and B, for next measuring process in the time interval $\Delta t$. For the both sets A and B a equation for a matrix of individual currents $\begin{bmatrix} -\overline{I}_{mA1} \\ -\overline{I}_{mB1} \end{bmatrix}$ is formulated having an error ratio matrix as unknown, according to the formula:

$$\begin{bmatrix} \overline{I}_{mA2} & \overline{I}_{mA3} & \cdots & \overline{I}_{mAn} \\ \overline{I}_{mB2} & \overline{I}_{mB3} & \cdots & \overline{I}_{mBn} \end{bmatrix} \begin{bmatrix} \overline{E}_1 \cdot \overline{E}_2^{-1} \\ \overline{E}_1 \cdot \overline{E}_3^{-1} \\ \vdots \\ \overline{E}_1 \cdot \overline{E}_n^{-1} \end{bmatrix} = \begin{bmatrix} -\overline{I}_{mA1} \\ -\overline{I}_{mB1} \end{bmatrix} \qquad (1.6)$$

Next solving and equation (1,6) an error ratio $matrix\_\overline{E}_1 \cdot \overline{E}_n^{-1}$ for all current transformer is calculated by using the both sets A and B of new individual current signals according to the formula:

$$\begin{bmatrix} \overline{E}_1 \cdot \overline{E}_2^{-1} \\ \overline{E}_1 \cdot \overline{E}_3^{-1} \\ \vdots \\ \overline{E}_1 \cdot \overline{E}_n^{-1} \end{bmatrix} = \begin{bmatrix} -\overline{I}_{mA1} \\ -\overline{I}_{mB1} \end{bmatrix} \begin{bmatrix} \overline{I}_{mA2} & \overline{I}_{mA3} & \cdots & \overline{I}_{mAn} \\ \overline{I}_{mB2} & \overline{I}_{mB3} & \cdots & \overline{I}_{mBn} \end{bmatrix}^{-1} \qquad (1.7)$$

where:

$\overline{I}_{mAn}$ - signal measured by $n^{th}$ current transformer for the first set A,

$\overline{I}_{mBn}$ - signal measured by $n^{th}$ current transformer for the second set B after time interval $\Delta t$,

$\overline{E}_n$-complex error introduced by $n^{th}$ current transformer,

$\overline{E}_n^{-1}$ - inversed complex error introduced by $n^{th}$ current transformer,

$\overline{E}_1 \cdot \overline{E}_n^{-1}$ - error ratio matrix.

**Step #4**

The error ratio $matrix\_\overline{E}_1 \cdot \overline{E}_n^{-1}$ of each measured current signals is sent to the buffer module 205 for using the data in the next interval with time $\Delta t$ for updating the complex error $\overline{E}_n$ given in the first step. The updated process is performed continuously and compensated the current error in each transformer of a number of transformers working at the same time.

**Claims**

1. A method of compensating current transformer errors during measuring the current signals $\overline{I}_{m\_n}$ and using a current amplitude error ($Amp_n$) and a current phase error ($\delta_n$) for determining an complex error ($\overline{E}_n$) for a current transformers (6) working at the same time in an automation station (4) and connected with a common node busbar (3) comprising the following steps:

• connecting a secondary winding of each transformer (6) with a protection electronic device (5) installed in the automation station (4) or with a central control unit (8) through electronic device (5) and communication channel (9),

• measuring the current signals $\overline{I}_{mn}$ of each of the n-current transformer (6) in a given by a user time intervals ($\Delta$t) for preparing at least two sets of measured data, a set (A) and a set (B), where each set comprises measured current signals $\overline{I}_{m\_n}$,

• determination a matrix of an error ratio $\left( \overline{E}_1 \cdot \overline{E}_n^{-1} \right)$ for all $n^{th}$ current transformer with the sets (A) and (B) of measured data according to the formula:

$$\begin{bmatrix} \overline{E}_1 \cdot \overline{E}_2^{-1} \\ \overline{E}_1 \cdot \overline{E}_3^{-1} \\ \vdots \\ \overline{E}_1 \cdot \overline{E}_n^{-1} \end{bmatrix} = \begin{bmatrix} -\overline{I}_{mA1} \\ -\overline{I}_{mB1} \end{bmatrix} \begin{bmatrix} \overline{I}_{mA2} & \overline{I}_{mA3} & \cdots & \overline{I}_{mAn} \\ \overline{I}_{mB2} & \overline{I}_{mB3} & \cdots & \overline{I}_{mBn} \end{bmatrix}^{-1}$$

where:

$\overline{I}_{mAn}$ - is a signal measured by $n^{th}$ current transformer for the first set A,

$\overline{I}_{mBn}$ - is a signal measured by $n^{th}$ current transformer for the second set B after time interval $\Delta$t,

$\overline{E}_n$ - is a complex error introduced by n current transformer,

$\overline{E}_n^{-1}$ - is an inversed complex error introduced by current transformer,

• updated automatically the complex error ($\overline{E}_n$) for each current transformer using the matrix of an error ratio $\left( \_\overline{E}_1 \cdot \overline{E}_n^{-1} \right)$ detrmined in the previous steps.

2. A method according to claim 1, **characterized in that** it is performed in the protection electronic device (5) with using an analog to digital module (201) for gathering measured signals $\overline{I}_{m\_n}$ for at least two current transformers and using and a communication module (202) for communication with other protection electronic device (5) through a communication channel (9).

3. A method according to claim 1, **characterized in that** it is performed in the protection electronic device (5) with using an analog to digital module (201) for gathering measured signals $\overline{I}_{m\_n}$ for at least two current transformers and using and a communication module (202) for communication with a central control unit (8) through a communication channel (9).

4. A method according to claims 1-3, **characterized in that** the protection electronic device (5) is protection relay or a merging unit.

5. A method according to claims 1-3, **characterized in that** the central control unit (8) is an industrial PC or a substation server.

6. A computer program product for compensating current transformer errors during measuring the current signals $\overline{I}_{m\_n}$, which program product is loadable into and executable in the computer means having the form of a protection electronic device (5) or a central control unit (8), **characterized in that** during program run it executes the method according to any claims 1-5.

Fig. 1

Fig. 2

$5_n$

$5_1$

8

$\overline{I}_{m\_1}$ ... $\overline{I}_{m\_n}$

$\overline{E}_1$ ... $\overline{E}_n$

9

8

Clock

205

202

203 → 204

Δt

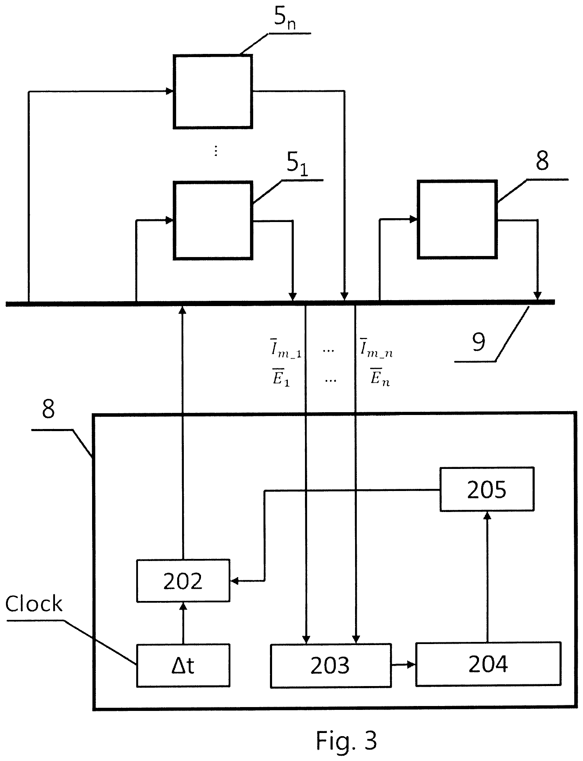

Fig. 3

$$\Delta t, \overline{E}_n$$

$$\overline{I}_{m\_n}$$

$$\overline{E}_1 \cdot \overline{E}_n^{-1}$$

$$\begin{bmatrix} \overline{E}_1 \cdot \overline{E}_2^{-1} \\ \vdots \\ \overline{E}_1 \cdot \overline{E}_n^{-1} \end{bmatrix}$$

Fig. 4

Europäisches
Patentamt

European
Patent Office

Office européen
des brevets

## EUROPEAN SEARCH REPORT

Application Number

EP 17 46 0073

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/109507 A1 (KHALIN VLADIMIR M [US] ET AL) 15 August 2002 (2002-08-15)<br>* figures 2-3 *<br>* paragraph [0013] *<br>* paragraphs [0016] - [0019] *<br>* paragraphs [0024] - [0026] * | 1-6 | INV.<br>G01R35/02<br><br>ADD.<br>G01R19/25<br>G01R31/02 |
| X | CN 102 508 190 A (SICHUAN ELEC POWER RES INST) 20 June 2012 (2012-06-20)<br>* the whole document * | 1-6 | |
| A,D | US 2016/209446 A1 (KAJI SAMIR [IN]) 21 July 2016 (2016-07-21)<br>* figure 2 *<br>* paragraphs [0003] - [0009] *<br>* paragraphs [0041] - [0055] *<br>* paragraphs [0058] - [0060] * | 1-6 | |
| A | US 5 309 312 A (WILKERSON TIMOTHY M [US] ET AL) 3 May 1994 (1994-05-03)<br>* the whole document * | 3-5 | |
| | | | TECHNICAL FIELDS SEARCHED (IPC) |
| A | US 2017/331278 A1 (WEILBIER JOERG [DE]) 16 November 2017 (2017-11-16)<br>* figure *<br>* paragraphs [0001] - [0016] * | 1 | G01R |
| A | CN 101 071 142 A (XUJI GROUP CO LTD [CN]) 14 November 2007 (2007-11-14)<br>* the whole document * | 1 | |
| A | EP 3 118 645 A1 (LSIS CO LTD [KR]) 18 January 2017 (2017-01-18)<br>* figures 2-6 *<br>* paragraphs [0028] - [0042] * | 1-6 | |

The present search report has been drawn up for all claims

| Place of search | Date of completion of the search | Examiner |
|---|---|---|
| Munich | 25 May 2018 | Danisi, Alessandro |

EPO FORM 1503 03.82 (P04C01)

## ANNEX TO THE EUROPEAN SEARCH REPORT
## ON EUROPEAN PATENT APPLICATION NO.

EP 17 46 0073

This annex lists the patent family members relating to the patent documents cited in the above-mentioned European search report.
The members are as contained in the European Patent Office EDP file on
The European Patent Office is in no way liable for these particulars which are merely given for the purpose of information.

25-05-2018

| Patent document cited in search report | | Publication date | Patent family member(s) | | Publication date |
|---|---|---|---|---|---|
| US 2002109507 | A1 | 15-08-2002 | CA | 2370754 A1 | 15-08-2002 |
| | | | US | 2002109507 A1 | 15-08-2002 |
| CN 102508190 | A | 20-06-2012 | CN | 102508190 A | 20-06-2012 |
| | | | WO | 2013063856 A1 | 10-05-2013 |
| US 2016209446 | A1 | 21-07-2016 | EP | 3036749 A2 | 29-06-2016 |
| | | | US | 2016209446 A1 | 21-07-2016 |
| | | | WO | 2015025332 A2 | 26-02-2015 |
| US 5309312 | A | 03-05-1994 | CA | 1330234 C | 14-06-1994 |
| | | | US | 5309312 A | 03-05-1994 |
| US 2017331278 | A1 | 16-11-2017 | EP | 3180828 A1 | 21-06-2017 |
| | | | US | 2017331278 A1 | 16-11-2017 |
| | | | WO | 2016055123 A1 | 14-04-2016 |
| CN 101071142 | A | 14-11-2007 | NONE | | |
| EP 3118645 | A1 | 18-01-2017 | EP | 3118645 A1 | 18-01-2017 |
| | | | KR | 20170009352 A | 25-01-2017 |
| | | | US | 2017016973 A1 | 19-01-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016209446 A
- KR 101431685